# EUROPEAN PATENT APPLICATION

(11) **EP 4 250 364 A1**
(43) Date of publication of application: **27.09.2023**
(21) Application number: 22163446.2
(22) Date of filing: 22.03.2022
(51) Int. Cl.: H01L 29/06, H01L 29/10, H01L 29/732, H01L 29/872, H01L 29/78

(54) **A VERTICAL ORIENTED SEMICONDUCTOR DEVICE HAVING A REDUCED LATERAL FIELD TERMINATION DISTANCE, AS WELL AS A CORRESPONDING METHOD**

(71) Applicant: Nexperia B.V., 6534 AB Nijmegen (NL)
(72) Inventor: Berglund, Stefan, 22529 Hamburg (DE); Holland, Steffen, 22529 Hamburg (DE); Böttcher, Tim, 22529 Hamburg (DE); Bae, Seong-Woo, 22529 Hamburg (DE)
(74) Representative: Pjanovic, Ilija

(57) **Abstract**

A vertical oriented semiconductor device, preferably a BJT, comprising a semiconductor body having a first major surface, the semiconductor body comprising a first region (7) of a first conductivity type and a second region (5) of a second conductivity type, wherein said second region is formed in said first region such that a PN junction is provided between said first region and said second region, said junction having a maximum distance to said first major surface, wherein said semiconductor device further comprises a trench (12) extending into the semiconductor body from the first major surface to an extension depth at least equal to said maximum distance, wherein said trench comprises a material arranged to provide electrical insulation to thereby limit a lateral field termination distance associated with said junction.

## Description

### Technical field

The present disclosure relates to the field of semiconductors and, more specifically, to the field of lateral field terminations for preventing lateral breakdown in reverse bias of the corresponding semiconductors

### Background

The present disclosure is directed to vertical discrete semiconductor devices. A vertical discrete semiconductor device is a device that has a vertical channel structure such that the current flows vertically from one side of the silicon wafer to the opposing second side of the wafer.

One of such a semiconductor device is a Bipolar Junction Transistor, BJT, which, typically comprises an emitter region towards a first major surface of the BJT and a collector region formed on a second major surface, opposite to the first major surface.

A base region is provided between the emitter and collector region, which base region is of a different conductivity type to that of the emitter and collector region.

Typical for the vertical structured BJT, or for any vertical semiconductor device, is that the current is conducted vertically from one surface to the other so as to achieve high drive capability.

Such BJTs may be able to cope with high reverse bias voltages between the emitter region and the collector region, without that the BJT will break down or pass any significant reverse current.

The above is typically achieved by introducing a drift region between the collector region and the base region, wherein the drift region has the same conductivity type as the emitter region and the collector region. The drift region, however, typically has a lower doping concentration. The collector region forms a PN junction at the interface with the base region which serves to block the reverse bias current.

Any vertical semiconductor device provides some sort of field termination around the periphery of the semiconductor die in order to avoid premature lateral breakdown in reverse bias operation. Field termination may occupy a lot of space on the chip area and may need additional channel diffusion in the sawing lane. This is die area that is of no use for the actual device function. It is just needed to grant reliability and the ability to handle the required voltage in reverse bias.

### Summary

A summary of aspects of certain examples disclosed herein is set forth below. It should be understood that these aspects are presented merely to provide the reader with a brief summary of these certain embodiments and that these aspects are not intended to limit the scope of this disclosure. Indeed, this disclosure may encompass a variety of aspects and/or a combination of aspects that may not be set forth.

It is an object of the present disclosure to provide for a vertical oriented semiconductor device having a reduced lateral field termination distance. It is a further object of the present disclosure to provide for a corresponding method.

In a first aspect, there is provided a vertical oriented semiconductor device comprising a semiconductor body having a first major surface, the semiconductor device comprising:
- a substrate;
- a first region, for example an epitaxial layer, provided on said substrate and having a first conductivity type;
- a conductive element provided on said first region, wherein a breakdown voltage of said semiconductor device depends on a distance between said conductive element and said substrate or depends on a doping level of the first region;
   wherein said trench comprises a material arranged to provide electrical insulation to thereby limit a lateral field termination distance associated with said breakdown voltage.

In an example, said semiconductor device further comprises a trench extending into the semiconductor body from the first major surface to an extension depth at least covering said conductive element.

The inventors have found that the field terminal distance can be made much more compact by utilizing a trench that is arranged to provide electrical insulation.

The trench may thus be filled with material having a relative high breakdown field strength such that much less lateral space is required on the chip periphery compared to, for example, lowly doped Silicon. This save much die area and thus also saves costs. Another effect is that the channel diffusion in the sawing lane can be omitted, thus further saving die space and a mask layer.

The trench thus provides for an electrical insulation function, such that any electrical field induced at the junction will not be able to cause electrical breakdown, or significant leakage current, in the trench laterally.

In an example, the trench is electrically floating.

The above entails that the trench is not connected to the outside world, i.e. not electrically connected to any drain, source, gate or any other type of terminal. The trench may thus be disconnected from any electrical terminal of the semiconductor device.

In a further example, the trench integrally comprises, or solely comprises, undoped material. That is, any material used in the trench is undoped, making the trench a good isolator for electrical fields. In a further example, the trench integrally comprises, or solely comprises, of electrically non-conductive material.

In another example, the trench extends from said first major surface at a location at a non-zero distance from an active region of said semiconductor device, or at a location comprised within said conductive element.

The inventors have found that the exact lateral location at which the trench extends downwards may differ from application to application. The trench may even penetrate the conductive element. The trench may be covered by a thermal oxide, for example a high quality thermal oxide, to provide defect free interfaces.

It is noted that the breakdown voltage of said semiconductor device depends on a distance between said conductive element and said substrate but may additionally depend on a doping level of the first region.

In an example, the trench extends into any of said first region and said substrate.

In a further example, the conductive element is any of:
- a second region having a second conductive type opposite to said first opposite type, such that a junction is provided between said first and second region;
- a functional trench of a Metal Oxide Semiconductor, MOS, Field Effect Transistor, FET;
- a metal barrier of a Schottky diode.

The conductive element may be a second region having a second conductive type which is opposite to the first opposite type. This results in a situation in that a junction is provided between the first and second region. This is, for example, the case in a PN diode or a Bipolar Junction Transistor, BJT.

The conductive element may also be a functional trench of a MOSFET. The functional trench may, for example, be connected to the gate terminal or the source terminal of the MOSFET.

The conductive element may also be a metal barrier of a Schottky diode.

In accordance with the present disclosure, there is a transition between the first region and the conductive element. The distance between this particular transition and the substrate determines, at least to a certain extent, the rated breakdown voltage of the semiconductor device. It is undesired if the semiconductor would breakdown laterally. As such, prior art solutions have been focussed on getting a particular lateral field termination distance in place that is long enough such that lateral breakdown will not occur.

In accordance with the present disclosure, the above mentioned lateral field termination distance can be reduced. This is accomplished by introducing the isolating trench. That trench extends into the semiconductor body from the first major surface to an extension depth at least covering the conductive element. The extension depth may thus be equal to the dept of the above defined transition, i.e. the depth in the semiconductor device at which the transition between the first region and the conductive element occurs.

A Bipolar Junction Transistor, BJT, may be manufactured as follows. A semiconductor layer may be formed on a semiconductor substrate using known techniques such as epitaxial growth or deposition. Often, the semiconductor layer is formed of silicon and is formed of the same conductivity as the semiconductor substrate which is, for example, of the N-type. The semiconductor layer may define a collector region or drift region. The collector region or drift region may be considered the first region in accordance with the present disclosure.

It is noted that a diffusion of an opposite doping compared to the collector region or drift region is made from the front side of the wafer. The resulting PN junction needs to withstand the maximum blocking voltage of the device.

For device reliability this PN junction may need to have lateral breakdown at a higher voltage than vertically. Therefore the distance to, and from, the PN junction to the channel must vertically be large enough. By applying a trench filled with material of high breakdown strength and extending to the same depth or deeper than the PN junction, the lateral distance from the PN junction to the channel diffusion in the sawing lane or to the die edge can be significantly reduced thus saving die area.

In accordance with the present disclosure, an isolating trench is provided. The isolating trench is suitable for providing electrical isolation for reducing the lateral field termination distance. The isolation trench may also be formed by any appropriate etching technique such that it terminates in any of the layers of the semiconductor device and at least covers the conductive element, i.e. it should penetrate into the semiconductor body to at least the transition between the first region and the conductive element. That is, the depth of the isolation trench is such that it, vertically speaking, at least equals the depth of the transition. The isolation trench may penetrate the semiconductor device even further for improved results, i.e. for an even further reduced lateral field termination distance.

The isolating trench does not aid in functioning of the semiconductor device. The additional trench does not influence the behaviour of the semiconductor device itself, i.e. it does not influence the BJT, or anything alike. The isolation trench assures that there is a high insulation present to reduce any distance that is required to cope with the high breakdown voltage, i.e. the lateral field termination distance.

In an example, the material comprises any of, or solely of:
- Silicon Oxide,
- Silicon Nitride,
- undoped Polysilicon.

In another example, the first region is a P-type region and said conductive element is a second region being an N-type region such that a PN junction is provided or the first region is an N-type region and wherein said conductive element is a second region being a P-type region such that a PN junction is provided.

In a second aspect of the present disclosure there is provided a method of manufacturing a vertical oriented semiconductor device in accordance with any of the previous claims, said method comprises the steps of:
- forming a semiconductor substrate;
- forming a first region, for example an epitaxial layer, on said substrate, said first region having a first conductivity type;
- forming a conductive element on said first region, wherein a breakdown voltage of said semiconductor device depends on a distance between said conductive element and said substrate;
- forming a trench extending into the semiconductor body from the first major surface to an extension depth at least covering said conductive element, wherein said trench comprises a material arranged to provide electrical insulation to thereby limit a lateral field termination distance associated with said breakdown voltage.

It is noted that the advantages as explained with reference to the first aspect of the present disclosure, being the vertical semiconductor device, are also applicable to the second aspect of the present disclosure, being the method of manufacturing a vertical oriented semiconductor device.

The present disclosure is described in conjunction with the appended figures. It is emphasized that, in accordance with the standard practice in the industry, various features are not drawn to scale. In fact, the dimensions of the various features may be arbitrarily increased or reduced for clarity of discussion.

In the appended figures, similar components and/or features may have the same reference label. Further, various components of the same type may be distinguished by following the reference label by a dash and a second label that distinguishes among the similar components. If only the first reference label is used in the specification, the description is applicable to any one of the similar components having the same first reference label irrespective of the second reference label.

The above and other aspects of the disclosure will be apparent from and elucidated with reference to the examples described hereinafter.

### Brief description of the drawings

Fig. 1 discloses an example of a semiconductor device having field termination in accordance with the prior art;
Fig. 2 discloses an example of a semiconductor device having field termination in accordance with the present disclosure;
Fig. 3 discloses another example of a semiconductor device having field termination in accordance with the present disclosure;
Fig. 4 discloses another example of a semiconductor device having field termination in accordance with the present disclosure;
Fig. 5 discloses another example of a semiconductor device having field termination in accordance with the present disclosure;
Fig. 6 discloses another example of a semiconductor device having field termination in accordance with the present disclosure.

### Detailed Description

It is noted that in the description of the figures, same reference numerals refer to the same or similar components performing a same or essentially similar function.

A more detailed description is made with reference to particular examples, some of which are illustrated in the appended drawings, such that the manner in which the features of the present disclosure may be understood in more detail. It is noted that the drawings only illustrate typical examples and are therefore not to be considered to limit the scope of the subject matter of the claims. The drawings are incorporated for facilitating an understanding of the disclosure and are thus not necessarily drawn to scale. Advantages of the subject matter as claimed will become apparent to those skilled in the art upon reading the description in conjunction with the accompanying drawings.

The ensuing description above provides preferred exemplary embodiment(s) only, and is not intended to limit the scope, applicability or configuration of the disclosure. Rather, the ensuing description of the preferred exemplary embodiment(s) will provide those skilled in the art with an enabling description for implementing a preferred exemplary embodiment of the disclosure, it being understood that various changes may be made in the function and arrangement of elements, including combinations of features from different embodiments, without departing from the scope of the disclosure.

Unless the context clearly requires otherwise, throughout the description and the claims, the words "comprise," "comprising," and the like are to be construed in an inclusive sense, as opposed to an exclusive or exhaustive sense; that is to say, in the sense of "including, but not limited to." As used herein, the terms "connected," "coupled," or any variant thereof means any connection or coupling, either direct or indirect, between two or more elements; the coupling or connection between the elements can be physical, logical, electromagnetic, or a combination thereof. Additionally, the words "herein," "above," "below," and words of similar import, when used in this application, refer to this application as a whole and not to any particular portions of this application. Where the context permits, words in the Detailed Description using the singular or plural number may also include the plural or singular number respectively. The word "or," in reference to a list of two or more items, covers all of the following interpretations of the word: any of the items in the list, all of the items in the list, and any combination of the items in the list.

These and other changes can be made to the technology in light of the following detailed description. While the description describes certain examples of the technology, and describes the best mode contemplated, no matter how detailed the description appears, the technology can be practiced in many ways. Details of the system may vary considerably in its specific implementation, while still being encompassed by the technology disclosed herein. As noted above, particular terminology used when describing certain features or aspects of the technology should not be taken to imply that the terminology is being redefined herein to be restricted to any specific characteristics, features, or aspects of the technology with which that terminology is associated. In general, the terms used in the following claims should not be construed to limit the technology to the specific examples disclosed in the specification, unless the Detailed Description section explicitly defines such terms. Accordingly, the actual scope of the technology encompasses not only the disclosed examples, but also all equivalent ways of practicing or implementing the technology under the claims.

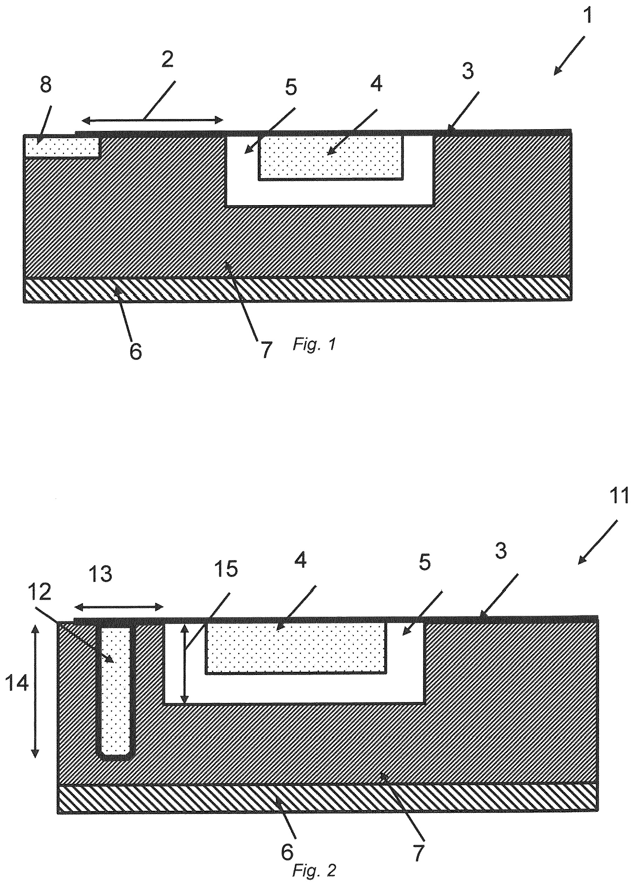

Fig. 1 discloses an example of a semiconductor device 1 having field termination in accordance with the prior art.

Figure 1 discloses a generic example of a semiconductor device 1 in accordance with the prior art. It is noted that the semiconductor device may be any of a bipolar transistor, a Schottky or PN diode, an insulated-gate bipolar transistor, IGBT, Metal Oxide Semiconductor, MOS, Field Effect Transistor, FET.

The semiconductor device 1 may comprise a substrate 6 on top of which an epitaxial layer 7 is provided. The substrate 6 may, for example, form the collector region of the BJT.

The epitaxial layer 7 may be considered as a first region. The first region may, for example, be the collector region. The collector region 7 is of a first conductivity type, for example P-type. The semiconductor device further comprises a second region which is indicated with the reference numeral 5. The second region may, for example, be the base region. The semiconductor may further comprises a third region which is indicated with reference numeral 4. The third region may be the emitter region.

In this particular case, two junctions are provided. A first junction is provided between the collector region 7 and the base region 5. A second junction is provided between the base region 5 and the emitter region 4.

The junction between the collector region 7 and the base region 5 provides the required breakdown voltage. The underlying idea is that the junction between the base region 5 and the collector region 7 is to breakdown vertically at a lower voltage compared to laterally. This ensures that the breakdown will not ensure in a lateral manner.

Known vertical semiconductors use a field termination between the outmost junction 5, 7 of the active component and the channel diffusion in the sawing lane. This field termination is usually of same magnitude or larger as the epi thickness of the semiconductor device in order to avoid lateral breakdown and associated reliability problems. A channel diffusion 8 may be present in the sawing lane. The lateral field termination distance is indicated with reference numeral 2.

Fig. 2 discloses an example of a semiconductor device 11 having field termination in accordance with the present disclosure.

The semiconductor device 11 in figure 2 is a bipolar junction transistor. It is noted that the present disclosure may be applicable to any vertically oriented semiconductor device.

The semiconductor device 11 comprises a substrate 6 on which a first region 7 is provided. The first region 7 is the epitaxial layer having a first conductivity type, for example P type. A conductive element 5 is provided on top of the first region 7. In this particular case, i.e. in the case of a bipolar junction transistor, the conductive element 5 is a second region having a second conductivity type, which second conductivity type is opposite to the first conductivity type. The second conductivity type may be the N type.

Following the above a transition occurs between the conductive element 5 and the first region 7. In this particular case, the transition is a PN junction. The PN junction is provided at a distance which is indicated with reference numeral 15.

The semiconductor device 11 further comprises a trench 12 extending into the semiconductor body from the first major surface 3 to an extension depth at least covering the conductive element 5, so that the trench extends to at least the PN junction 5, 7.

The distance in the semiconductor device, at which the PN junction occurs, is indicated with the reference numeral 15 and may equal the diffusion layer, for example a second region being a base layer in a transistor. The extension depth is indicated with reference numeral 14 and indicates how "deep" the trench penetrates into the semiconductor body. The extension depth 14 should at least equal the distance as indicated with reference numeral 15.

The trench 12 comprises a material arranged to provide electrical insulation to thereby limit a lateral field termination distance 13 associated with said junction 5, 7.

The lateral, for example horizontal in the figures, field termination distance 13 is reduced compared to the field termination distance 2 as shown in figure 1, as the trench provides for electrical insulation. This reduces the risk to a lateral breakdown in case of a high reverse voltage applied to the semiconductor device. That is, the trench 12 prevents any lateral breakdown to occur as the trench 12 has electrical insulation properties.

The trench 12 may comprise undoped isolation material like Silicon Oxide, Silicon Nitride, undoped Polysilicon or combinations thereof. The walls of the trench 12 may be provided with a thermal oxide in order to provide defect free interfaces.

The present disclosure has several advantages. First of all, less area of the die is required as the lateral breakdown distance is reduced. This saves costs. Second, a channel diffusion is no longer required further reducing costs and efforts.

It is noted that trenches are, of course, known in the art but they are not known as field termination on discrete small signal or power semiconductors. The present disclosure is thus directed to the use of a trench for insulation purposes and, more specific, for the use of a trench for reducing the lateral field termination distance.

The trench 12 may thus be applied around the periphery of a vertical semiconductor device 11.

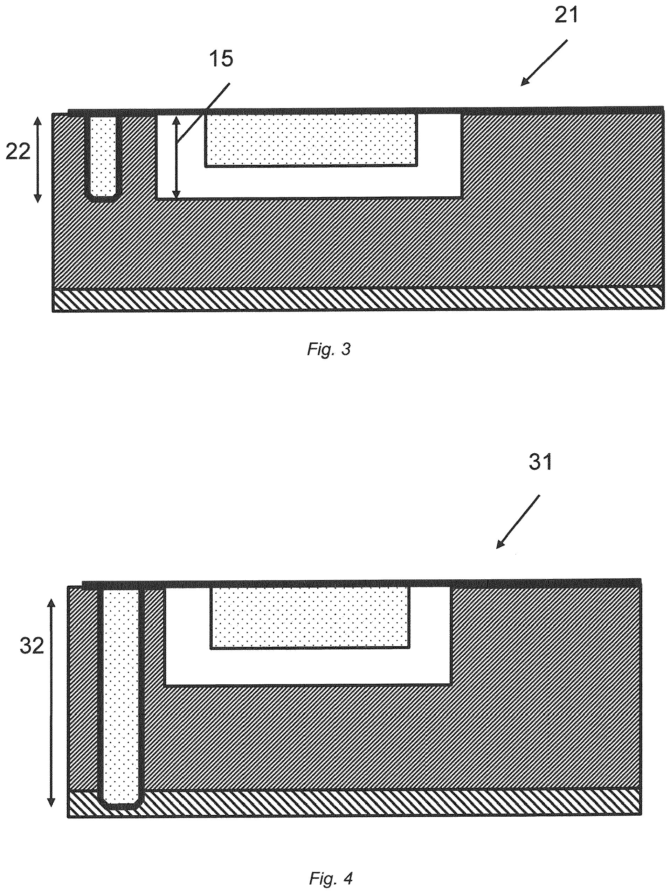

Fig. 3 discloses another example of a semiconductor device 21 having field termination in accordance with the present disclosure.

It is noted that the depth at which the trench penetrates into the semiconductor body, i.e. reference numeral 22, equals the distance of the junction in the semiconductor device as indicated with reference numeral 15. That is, the trench exactly covers the conductive element, i.e. the base region of the transistor. The inventors have found that it is beneficial if the penetration depth of the trench is at least equal to this particular distance 15.

Fig. 4 discloses another example of a semiconductor device 31 having field termination in accordance with the present disclosure. Here, it is shown that the trench penetrates into the substrate layer, as indicated with reference numeral 32.

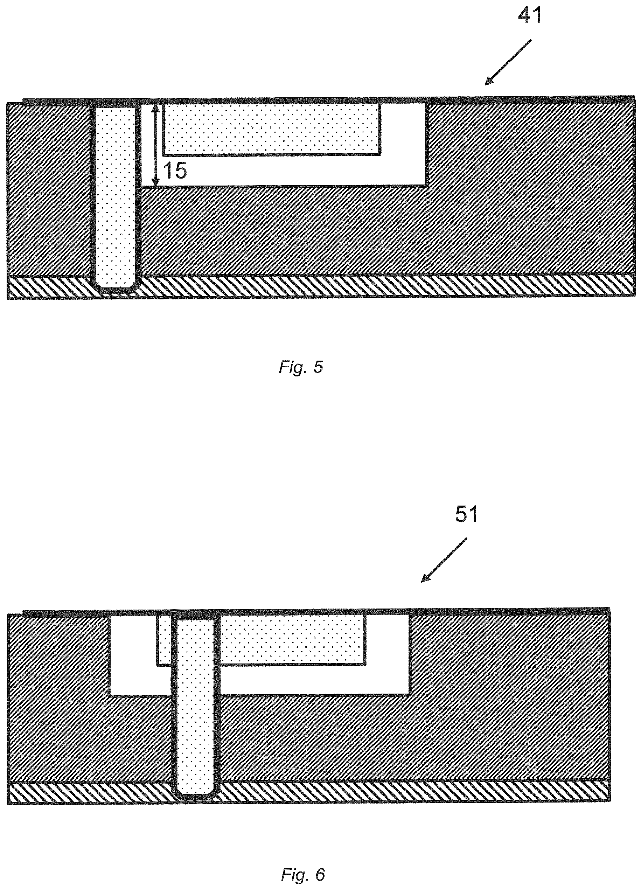

Fig. 5 and fig. 6 disclose another example of a semiconductor device 41, 51 having field termination in accordance with the present disclosure. Here it is shown that the horizontal, i.e. lateral, position of the trench is adjustable. That is, the trench may penetrate the epitaxial layer only, or may penetrate both the base region and the epitaxial layer, and may even also penetrate the emitter region 4.

In the above, the present disclosure is explained with respect to a Bipolar Junction Transistor having two junctions. It is noted that the present disclosure may be applicable for any vertical oriented semiconductor device having at least one junction between semiconductor material of a first type and semiconductor material of a second type. It is further noted that the present disclosure is also applicable for a semiconductor device having no PN junction, but having a transition between a metal part and a semiconductor material like, for example, a Schottky diode.

To reduce the number of claims, certain aspects of the technology are presented below in certain claim forms, but the applicant contemplates the various aspects of the technology in any number of claim forms. For example, while some aspect of the technology may be recited as a computer-readable medium claim, other aspects may likewise be embodied as a computer-readable medium claim, or in other forms, such as being embodied in a means-plus-function claim.
In the description above, for the purposes of explanation, numerous specific details are set forth in order to provide a thorough understanding of implementations of the disclosed technology. It will be apparent, however, to one skilled in the art that embodiments of the disclosed technology may be practiced without some of these specific details.

Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope thereof.

### LIST OF REFERENCE NUMERALS

- 1: Semiconductor device
- 2: Lateral field termination distance
- 3: First major surface
- 4: Third region
- 5: Conductive element
- 6: Substrate
- 7: First region
- 8: Channel Diffusion
- 11: Semiconductor device
- 12: Trench
- 13: Field termination distance
- 14: Extension depth
- 15: Junction distance
- 21: Semiconductor device
- 22: Extension depth
- 31: Semiconductor device
- 32: Extension depth
- 41: Semiconductor device
- 51: Semiconductor device

## Claims

1. A vertical oriented semiconductor device comprising a semiconductor body having a first major surface, the semiconductor device comprising:
- a substrate;
- a first region, for example an epitaxial layer, provided on said substrate and having a first conductivity type;
- a conductive element provided on said first region, wherein a breakdown voltage of said semiconductor device depends on a distance between said conductive element and said substrate or depends on a doping level of the first region;
wherein said trench comprises a material arranged to provide electrical insulation to thereby limit a lateral field termination distance associated with said breakdown voltage.

2. A vertical oriented semiconductor device in accordance with claim 1, wherein said semiconductor device further comprises a trench extending into the semiconductor body from the first major surface to an extension depth at least covering said conductive element.

3. A vertical oriented semiconductor device in accordance with any of the previous claims, wherein said trench is electrically floating.

4. A vertical oriented semiconductor device in accordance with any of the previous claims, wherein said trench is disconnected from electrical terminals of the device.

5. A vertical oriented semiconductor device in accordance with any of the previous claims, wherein said trench integrally comprises undoped material.

6. A vertical oriented semiconductor device in accordance with any of the previous claims, wherein said trench integrally comprises of electrically non-conductive material.

7. A vertical oriented semiconductor device in accordance with any of the previous claims, wherein said trench extends from said first major surface at a location at a non-zero distance from an active region of said semiconductor device, or at or at a location comprised within said conductive element

8. A vertical oriented semiconductor device in accordance with any of the previous claims, wherein said trench extends into any of said epitaxial layer and said substrate.

9. A vertical oriented semiconductor device in accordance with any of the previous claims, wherein said conductive element is any of:
- a second region having a second conductive type opposite to said first opposite type, such that a junction is provided between said first and second region;
- a functional trench of a Metal Oxide Semiconductor, MOS, Field Effect Transistor, FET;
- a metal barrier of a Schottky diode.

10. A vertical oriented semiconductor device in accordance with claim 9, wherein any of:
- said first region is a P-type region and said second region is an N-type region such that a PN junction is provided;
- said first region is an N-type region and wherein said second region is a P-type region such that a PN junction is provided.

11. A vertical oriented semiconductor device in accordance with any of the previous claims, wherein said material comprises any of:
- Silicon Oxide,
- Silicon Nitride,
- undoped Polysilicon.

12. A vertical oriented semiconductor device in accordance with any of the previous claims, wherein the semiconductor device is any of a bipolar transistor, a Zener, Schottky or PN diode, an insulated-gate bipolar transistor, IGBT, Metal Oxide Semiconductor, MOS, Field Effect Transistor, FET.

13. A method of manufacturing a vertical oriented semiconductor device in accordance with any of the previous claims, said method comprises the steps of:
- forming a semiconductor substrate;
- forming a first region, for example an epitaxial layer, on said substrate, said first region having a first conductivity type;
- forming a conductive element on said first region, wherein a breakdown voltage of said semiconductor device depends on a distance between said conductive element and said substrate;
- forming a trench extending into the semiconductor body from the first major surface to an extension depth at least covering said conductive element, wherein said trench comprises a material arranged to provide electrical insulation to thereby limit a lateral field termination distance associated with said breakdown voltage.
